# FASCICULE DE BREVET EUROPEEN

(11) **EP 3 416 284 B1**
(45) Date de publication et mention de la délivrance du brevet: **23.06.2021**
(21) Numéro de dépôt: 18175127.2
(22) Date de dépôt: 30.05.2018
(51) Int. Cl.: H03B 5/12

(54) **ARCHITECTURE DE PARTAGE DE TENSION ENTRE DEUX OSCILLATEURS**
ARCHITEKTUR MIT SPANNUNGSAUFTEILUNG ZWISCHEN ZWEI OSZILLATOREN
ARCHITECTURE FOR SHARING VOLTAGE BETWEEN TWO OSCILLATORS

(30) Priorité: 15.06.2017 FR 1755426
(43) Date de publication de la demande: 19.12.2018
(73) Titulaire: Commissariat à l'Energie Atomique et aux Energies Alternatives, 75015 Paris (FR)
(72) Inventeur: MARTINEAU, Baudouin, 38570 TENCIN (FR)
(74) Mandataire: Marks & Clerk France

(56) Documents cités:
- CN-A- 102 170 289
- KR-B1- 101 138 487
- US-A- 3 305 824
- US-A1- 2008 174 375
- US-A1- 2011 057 732
- US-A1- 2014 132 359
- US-A1- 2015 180 528
- HA KEUM-WON ET AL: "$G_{m}$ -Boosted Complementary Current-Reuse Colpitts VCO With Low Power and Low Phase Noise", IEEE MICROWAVE AND WIRELESS COMPONENTS LETTERS, IEEE SERVICE CENTER, NEW YORK, NY, US, vol. 24, no. 6, 30 juin 2014 (2014-06-30), pages 418-420, XP011550069, ISSN: 1531-1309, DOI: 10.1109/LMWC.2014.2313582 [extrait le 2014-06-03]

## Description

L'invention porte sur une architecture permettant un partage de tension entre deux oscillateurs électroniques. Elle relève du domaine de l'électronique analogique, et en particulier de l'électronique radiofréquence (RF), et s'applique notamment à la réalisation d'oscillateurs pilotés en tension (VCO, de l'anglais « Voltage Controlled Oscillator ») pour des émetteurs ou récepteurs RF.

La réduction d'échelle des technologies silicium menée au cours de ces dernières années a conduit à une forte réduction des tensions d'alimentation des transistors, ainsi que de la tension maximale pouvant être appliquée aux bornes de ces derniers. Il en résulte une forte limitation de l'amplitude maximale admissible des signaux pouvant être générés ou traités par des circuits utilisant ces transistors. A titre d'exemple, des transistors CMOS en technologie à 65 nm sont conçus pour supporter une tension drain-source de 1,32 V. Ces transistors sont généralement alimentés à 1,2 V ; dans le cas d'un oscillateur de type à paire différentielle croisée cela conduirait à une tension drain-source maximale atteignant environ 2,2 V au pic positif de l'oscillation. Afin d'assurer un fonctionnement fiable, on est donc amené à limiter la tension d'alimentation à environ 700 mV, et donc l'amplitude de crête du signal d'oscillation à ±500 mV seulement. Par exemple, dans l'article de J. L. González et al. « A 56-GHz LC-Tank VCO With 7% Tuning Range in 65-nm Bulk CMOS for Wireless HDMI », RFIC 2009 - IEEE Radio Frequency Integrated Circuits Symposium, 2009, décrit un oscillateur CMOS à paire différentielle croisée dans lequel un transistor PMOS est utilisé pour fournir un courant de polarisation à un niveau de tension inférieur à celui d'alimentation du circuit.

Cela a pour conséquence une diminution significative du rapport signal sur bruit (SNR, de l'anglais « Signal to Noise Ratio »), dû en particulier au bruit de phase. Cela affecte la pureté spectrale du signal d'oscillation, ce qui est indésirable en particulier dans les applications aux télécommunications.

Une première approche permettant d'adresser ce problème relève de la technologie microélectronique. Les fondeurs ont en effet introduit des nouvelles familles de transistors : transistor à double oxyde de grille (GO2) et transistor à drain étendu (LDMOS) pour les technologies CMOS, transistor haute tension en technologie bipolaire. Ce faisant, ils ont pu maintenir des tensions de l'ordre de 1,5V à 5V au prix d'une augmentation des coûts de fabrication. A titre d'exemple, la technologie UTBB FDSOI 28nm de STMicroelectronics dispose à la fois de transistors simple oxyde (tension maximum 1V) et double oxyde (tension maximum 1,5-1,8V). Cependant, ces tensions (1,5-1,8V) restent insuffisantes pour atteindre les niveaux de SNR requis dans les systèmes RF actuels.

Une deuxième approche, alternative ou complémentaire de la première, consiste à concevoir des montages permettant de repartir entre plusieurs transistors une tension d'alimentation trop élevée pour être directement appliquées aux bornes d'un seul dispositif. Par exemple, l'article de J. Dang et al « A fully integrated 5.5 GHz cross-coupled VCO with high output power using 0.25µm CMOS technology » 2014 21st IEEE International Conference on Electronics, Circuits and Systems (ICECS), Marseille, 2014, pp. 255-258 décrit un oscillateur comprenant une première paire différentielle de transistors PMOS croisés et une deuxième paire différentielle de transistors NMOS croisés. Les sources des transistors PMOS de la première paire sont connectées à une alimentation électrique, et leurs drains à ceux des transistors de la deuxième paire et aux bornes d'un circuit résonant LC parallèle. Les sources des transistors de la deuxième paire sont connectées à la masse. De cette façon, la tension d'alimentation est partagée entre les deux paires différentielles, ce qui permet d'obtenir un signal oscillatoire d'amplitude plus élevée que si une seule paire était utilisée. L'inconvénient de cette approche réside dans la nécessité d'utiliser des transistors PMOS, dont les performances - notamment en termes de bruit - sont moins bonnes que celles des transistors NMOS.

Une autre possibilité est d'utiliser des transistors en configuration « cascode ». Cette solution, cependant, impose des limitations de fréquence et dégrade le rendement du circuit.

De plus, le document US 2014/132359 A1 adresse un oscillateur avec un réglage d'un voltage de mode commun et les documents de brevet US2011/057732 A1, US2015/180528 A1, CN102170289 A, KR101138487 B1 ainsi que la publication de Ha Keum-Won et al: "Gm -Boosted Complementary Current-Reuse Colpitts VCO With Low Power and Low Phase Noise",IEEE MICROWAVE AND WIRELESS COMPONENTS LETTERS, IEEE SERVICE CENTER, NEW YORK, NY, US, vol. 24, no. 6 (2014-06-30), pages 418-420, divulguent deux oscillateurs mutuellement couplés.

L'invention vise à surmonter les inconvénients précités de l'art antérieur.

Un objet de l'invention, permettant d'atteindre ce but, est un système électronique comprenant un premier et un second oscillateur mutuellement couplés et présentant une même fréquence de résonance, chaque dit oscillateur comprenant un résonateur électrique, une cellule active ayant une résistance de petit signal négative reliée audit résonateur électrique, une borne d'alimentation électrique de ladite cellule active, une sortie pour un signal d'oscillation et une borne de connexion à un point de masse, caractérisé en ce que :
- la borne d'alimentation électrique du second oscillateur et la borne de connexion à un point de masse du premier oscillateur sont reliées à un même point, dit de masse dynamique ; et
- le système comprend également un amplificateur différentiel présentant une première entrée pouvant être connectée à une source de tension de référence, une seconde entrée reliée audit point de masse dynamique et une sortie reliée à une borne de contrôle du courant de polarisation de l'un parmi le premier et le deuxième oscillateur de manière à former une boucle de contre-réaction adaptée pour maintenir le potentiel dudit point de masse dynamique à un niveau constant, fonction de ladite tension de référence.

Selon des modes de réalisation particuliers de l'invention :
- Le système peut comprendre également un circuit combineur de signaux configuré pour additionner les tensions des signaux d'oscillation prélevés sur les sorties du premier et du deuxième amplificateur.
- Plus particulièrement, ce circuit combineur de signaux peut comprendre un transformateur comprenant un premier et un deuxième enroulement primaire, respectivement reliés aux sorties du premier et du deuxième oscillateur, et deux enroulement secondaires reliés en série et couplés respectivement au premier et au deuxième enroulement primaire.

- Lesdits enroulements primaires peuvent notamment être des inductances des résonateurs électriques des oscillateurs.
- Les bornes d'alimentation électrique desdits premier et deuxième oscillateur peuvent être reliées à des points milieux respectif desdits enroulements primaires.
- Le système peut comprendre également ladite source de tension de référence, configurée pour générer ladite tension de référence de valeur égale à la moitié de celle de ladite tension d'alimentation.
- Les résonateurs électriques desdits premier et deuxième oscillateur peuvent être des circuits LC parallèles.
- Les cellules actives desdits premier et deuxième oscillateur peuvent comprendre chacune au moins un transistor ayant une grille ou base, la sortie dudit amplificateur différentiel étant reliée à la base du transistor de la cellule active du premier oscillateur.
- Les cellules actives desdits premier et deuxième oscillateur peuvent comprendre chacune une paire différentielle de transistors croisés. Dans ce cas, la sortie dudit amplificateur différentiel peut être reliée électriquement, en courant continu, à des grilles ou bases des transistors croisés de la paire différentielle de la cellule active dudit premier oscillateur, et la grille ou base de chacun desdits transistor croisés de la paire différentielle de la cellule active dudit premier oscillateur peut être connectée au drain ou collecteur de l'autre transistor de la paire par l'intermédiaire d'un condensateur de découplage.
- Lesdits oscillateurs peuvent être des oscillateurs commandés en tension, configurés pour être commandés ensemble de manière à présenter une même fréquence d'oscillation.
- Le système peut comprendre également une source de tension continue d'alimentation reliée à la borne d'alimentation électrique dudit premier oscillateur.
- Lesdits oscillateurs peuvent être des oscillateurs à radiofréquence.
- Lesdits oscillateurs peuvent être co-intégrés de manière monolithique.

D'autres caractéristiques, détails et avantages de l'invention ressortiront à la lecture de la description faite en référence aux dessins annexés donnés à titre d'exemple et qui représentent, respectivement :
- La figure 1A, un schéma d'un système électronique selon un mode de réalisation de l'invention ;
- Les figures 1B et 1C, les schémas électrique des deux oscillateurs du système de la figure 1A ;
- La figure 2A, un graphique de l'allure du signal d'oscillation généré par l'oscillateur de la figure 1C pris isolément ;
- La figure 2B, un graphique de la densité spectrale du bruit de phase du signal de la figure 2A ;
- La figure 2C, le spectre du signal de la figure 2A ;
- La figure 3A, un graphique de l'allure des signaux d'oscillation générés par les deux oscillateurs du système électronique de la figure 1A ;
- La figure 3B, un graphique de l'allure du signal d'oscillation à la sortie du système électronique de la figure 1A ;
- La figure 3C, un graphique de la densité spectrale du bruit de phase du signal de la figure 3B ; et
- La figure 3D, le spectre du signal de la figure 3B.

L'invention se base sur le principe du partage d'une tension d'alimentation relativement élevée entre deux oscillateurs fonctionnant simultanément, dont les signaux peuvent être combinés de manière constructive afin d'améliorer leur rapport signal sur bruit. Ce partage est assuré et stabilisé par une boucle de contre-réaction.

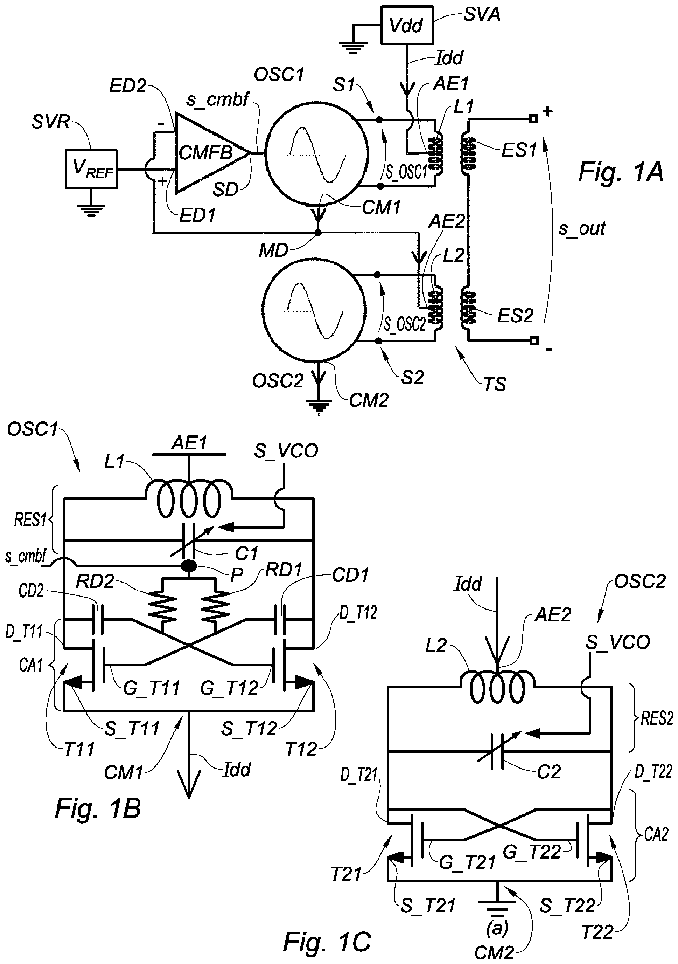

La figure 1A montre un schéma d'un système électronique selon un mode de réalisation de l'invention. Ce système comprend deux oscillateurs électroniques OSC1, OSC2 présentant une même fréquence de résonance, dont les schémas électriques sont illustrés sur les figures 1B et 1C, respectivement.

Chacun des deux oscillateurs OSC1, OSC2 comprend un résonateur électrique (RES1 pour OSC1, RES2 pour OSC2) et une cellule active (CA1 pour OSC1, CA2 pour OSC2) présentant une résistance de petit signal négative, permettant de compenser les pertes du résonateur. Dans le mode de réalisation considéré ici, les résonateurs RES1, RES2 sont des circuits LC parallèles : le résonateur RES1 comprend une inductance L1 montée en parallèle à un élément capacitif C1 et le résonateur RES2 comprend une inductance L2 montée en parallèle à un élément capacitif C2.

Dans la figure 1A, les inductances L1, L2 sont représentées à l'extérieur des blocs symbolisant les oscillateurs OSC1, OSC2 pour permettre une meilleure compréhension du fonctionnement du système électronique.

Dans de nombreuses applications on souhaite que les oscillateurs OSC1, OSC2 présentent une fréquence de résonance variable, et soient en particulier des VCO. Dans ce cas, les éléments capacitifs C1, C2 sont typiquement des jonctions PN polarisées inversement par une tension S_VCO qui détermine leur capacité. Il est important que les éléments capacitifs C1 et C2 soient contrôlés conjointement afin de maintenir l'égalité des fréquences de résonance des deux résonateurs.

Les cellules actives CA1, CA2 sont du type à paire différentielle de transistors croisés. Ainsi la cellule active CA1 du premier oscillateur OSC1 comprend deux transistors MOSFET identiques, T11 et T12, dont les sources S_T11, S_T12 sont connectées ensemble et les drains D_T11, D_T12 sont connectés à des bornes opposées de l'inductance L1 et de l'élément capacitif C1. La grille G_T11 du transistor T11 est connectée (par l'intermédiaire d'une capacité de découplage CD1 dont la fonction sera explicitée plus loin) au drain du transistor T12, et la grille G_T12 du transistor T12 est connectée (par l'intermédiaire d'une capacité de découplage CD2) au drain du transistor T11. De même, la cellule active CA2 du deuxième oscillateur OSC2 comprend deux transistors MOSFET identiques, T21 et T22, dont les sources S_T21, S_T22 sont connectées ensemble et les drains D_T21, D_T22 sont connectés à des bornes opposées de l'inductance L2 et de l'élément capacitif C2. La grille G_T21 du transistor T21 est connectée (directement, sans capacité de découplage) au drain du transistor T22, et la grille G_T22 du transistor T22 est connectée (également sans capacité de découplage) au drain du transistor T21.

Un courant continu d'alimentation I_{dd} est injecté dans les drains des transistors de chaque cellule active. Dans le mode de réalisation décrit ici, ce courant est fourni par l'intermédiaire d'une borne AE1, AE2 relié au point milieu de l'inductance L1, L2 de l'oscillateur.

Comme on peut le voir sur la figure 1A, une source SVA de tension continue d'alimentation est reliée à la borne d'alimentation AE1 de l'oscillateur OSC1 pour la maintenir à un potentiel V_{dd}. Le courant I_{dd}, issu de la source SVA, entre dans les drains D_T11, D_T12 des transistors T11, T12 de cet oscillateur et sort par leurs sources S_T11, S_T12. Ces dernières sont reliées à un point MD qui est appelé une « masse dynamique » car son potentiel ne varie pas lors du fonctionnement normal des oscillateurs. La borne d'alimentation AE2 du deuxième oscillateur OSC2 est également reliée à ce point MD. De cette façon, le courant I_{dd} entre également dans les drains D_T21, D_T22 des transistors T21, T22 de cet oscillateur et sort par leurs sources S_T21, S_T22. Ces dernières sont reliées à une masse du système électronique.

On comprend aisément que la tension drain-source moyenne des transistors T11, T12 de l'oscillateur OSC1 vaut V_{dd}-V_{MD}, où V_{MD} est la tension du point de masse dynamique MD, et celle des transistors T21, T22 de l'oscillateur OSC2 vaut V_{MD}. Ainsi, afin d'assurer une répartition constante de la tension d'alimentation entre les deux oscillateurs, il est nécessaire de stabiliser la tension V_{MD}.

Conformément à l'invention, cette stabilisation est obtenue grâce à un amplificateur de contre-réaction de mode commun (CMFB Common Mode Feed-Back Amplifier). Ce type d'amplificateur est bien connu de la littérature et peut, à titre d'exemple, être réalisé à partir d'un amplificateur opérationnel. L'amplificateur CMFB reçoit une tension continue, dite de référence (V_{REF}) sur l'une de ses entrées ED1 (entrée non inverseuse « + ») et la tension V_{MD} sur l'autre entrée ED2 (entrée inverseuse « - »), et fournit à sa sortie un signal s_cmbf proportionnel à la différence entre ces deux tensions. Ce signal, dont la fréquence est très inférieure à la fréquence de résonance f₀ des oscillateurs, est appliqué aux grilles G_T11, G_T12 des transistors T11, T12 de la cellule active CA1 du premier oscillateur OSC1 à travers des résistances RD1, RD2. Les capacités de découplage CD1, CD2 sont nécessaires car les drains de ces transistors sont maintenus à une tension moyenne V_{dd}, différente de s_cmbf. Les valeurs de ces capacités de découplage, et celles des résistances RD1, RD2, sont choisies de telle sorte que les capacités de découplage se comportent comme des circuits ouverts vis-à-vis du signal basse fréquence s_cmbf, et comme des courts-circuits à la fréquence de résonance f₀, permettant l'instauration d'une oscillation.

Ce montage forme une boucle de contre-réaction garantissant que V_{MD}=V_{REF}. En effet, si V_{MD} diminue et devient inférieur à V_{REF}, le niveau de tension du signal s_cmbf - et donc la tension de grille des transistors T11 et T12, augmente. En outre, comme la tension V_{MD} est appliquée aux grilles des transistors T21, T22, le courant I_{dd} parcourant les deux oscillateurs a également tendance à diminuer. Ces deux effets coopèrent pour provoquer une augmentation de la tension de source de T11 et T12. Mais cette tension de source n'est rien d'autre que V_{MD}, qui s'approche ainsi de V_{REF}. Inversement, si V_{MD} augmente et dépasse V_{REF}, la boucle de contre-réaction intervient pour la réduire.

Le fonctionnement du système peut être décrit de manière synthétique de la manière suivante. Les deux oscillateurs sont connectés en série en régime continu : ils sont donc traversés par un même courant de polarisation I_{dd}. L'oscillateur OSC2 est auto-polarisé et impose une relation entre la valeur de I_{dd} et celle du potentiel V_{MD}. Le signal s_cmbf est appliqué à une borne de contrôle du courant de polarisation traversant OSC1 (un point - référence P sur la figure 1A - relié aux grille des transistors T11 et T12) ; ce signal détermine la valeur de I_{dd}. La boucle de contre-réaction fixe la valeur de s_cmbf, et donc de I_{dd}, de telle sorte que le potentiel V_{MD} prenne la valeur voulue, égale à (ou, plus généralement, fonction de) V_{REF}.

Dans l'exemple de la figure 1A, V_{REF}=V_{dd}/2, ce qui implique V_{M}=V_{dd}/2. Cela signifie que la tension d'alimentation est repartie de manière égale entre les deux oscillateurs. Ce choix est optimal si les oscillateurs (ou au moins leurs transistors) sont identiques, mais il est tout à fait possible de repartir la tension de manière inégale en choisissant V_{REF}≠V_{dd}/2, en particulier si les transistors des deux oscillateurs présentent des canaux de largeurs différentes.

Dans l'exemple de la figure 1A, la tension de référence V_{REF} est générée par une source de tension SVR qui peut être tout simplement un partiteur de tension relié entre une sortie de la source d'alimentation SVA et la masse, mais d'autres modes de réalisation sont possibles.

Les oscillateurs OSC1, OSC2 génèrent des signaux d'oscillation s_osc1, s_osc2 d'une même fréquence, dont les amplitudes dépendent des tensions drain-source moyennes des transistors desdits oscillateurs. Ainsi l'amplitude du signal s_osc1 généré par l'oscillateur OSC1 dépend de V_{dd}-V_{REF}, tandis que celle du signal s_osc2 généré par l'oscillateur OSC2 dépend seulement de V_{REF}. Les amplitudes sont égales si les oscillateurs sont identiques et V_{REF}=V_{dd}/2. Ces deux signaux peuvent être prélevés sur des portes de sortie S1, S2 dont les terminaux sont reliés aux drains des transistors des oscillateurs respectifs ou, de manière équivalentes, aux bornes des inductances L1, L2 et des éléments capacitifs C1, C2. Ils peuvent ensuite être combinés, cet à dire sommés, pour obtenir un signal de sortie s_out d'amplitude plus élevé, donc moins sujet au bruit de phase. Dans le mode de réalisation de la figure 1A cela est obtenu grâce à un transformateur TS présentant deux enroulements secondaires ES1, ES2 connectés en série et couplés de manière inductive aux inductances L1, L2 qui jouent le rôle d'enroulements primaires.

Pour que la combinaison des deux signaux d'oscillation conduise à la génération d'un signal de sortie d'amplitude plus importante, il est nécessaire que les deux oscillateurs soient accordés (présentent donc une même fréquence d'oscillation) et synchronisés (c'est-à-dire qu'ils oscillent au moins approximativement en phase). En pratique, cela est obtenu de manière automatique grâce aux couplages mutuels nécessairement présents. Ces couplages sont dus d'une part au transformateur TS, et d'autre part à la proximité physique des oscillateurs, surtout lorsqu'ils sont co-intégrés de manière monolithique.

L'article de S. A. R. Ahmadi-Mehr, M. Tohidian et R. B. Staszewski, "Analysis and Design of a Multi-Core Oscillator for Ultra-Low Phase Noise," IEEE Transactions on Circuits and Systems I: Regular Papers, vol. 63, no. 4, pp. 529-539, Avril 2016, décrit un système exploitant le couplage entre deux oscillateurs électroniques.

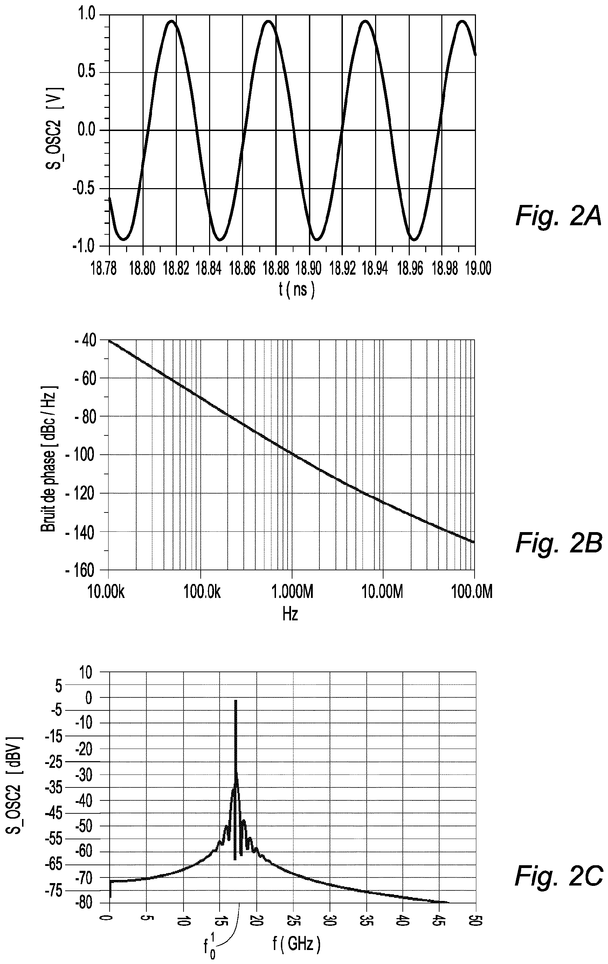

La figure 2A montre l'allure d'un signal d'oscillation d'un oscillateur du type de la figure 1C présentant une tension d'alimentation de 1,2 V. Le signal est sinusoïdal, avec une fréquence f₀¹=17,12 GHz. La figure 2B montre que ce signal est affecté par un bruit de phase dont la densité spectrale de puissance rapportée à la puissance du signal à 17,12 MHz (et mesurée en dBc/Hz) est illustrée sur la figure 2B. On peut voir que, à 1 MHz, le niveau de bruit vaut environ -99,4 dBc/Hz. Cela est suffisant pour affecter la pureté spectrale du signal, comme on peut le voir sur la figure 2C.

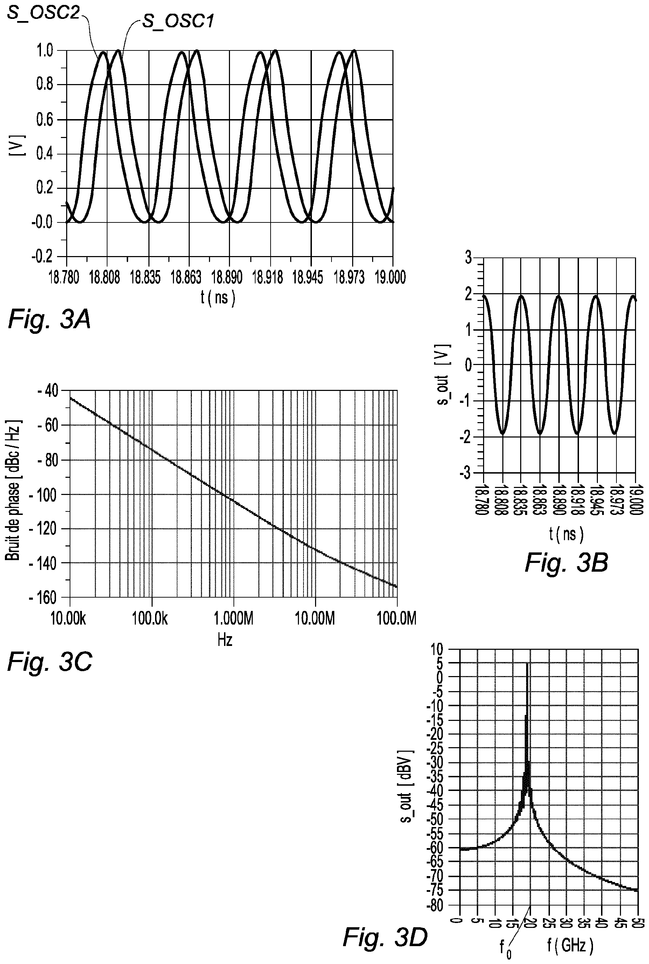

La figure 3A montre les deux signaux d'oscillation, s_osc1 et s_osc2 générés par un système électronique du type des figures 1A - 1C ; ces signaux présentent une même fréquence et une relation de phase constante, même s'ils ne sont pas exactement en phase entre eux. A cause de la présence du transformateur TS et du couplage mutuel des oscillateurs, la fréquence de ces signaux est légèrement modifiée par rapport à celle d'un oscillateur seul, et vaut f₀=18,85 MHz. La figure 3B montre l'allure du signal s_out obtenue en combinant les deux signaux individuels s_osc1 et s_osc2 : on peut observer que l'amplitude pic à pic de s_out vaut presque 4V. La figure 3B montre que le bruit de phase présente une densité spectrale de puissance d'environ -104,4 dBc/Hz, soit une amélioration de 5 bBc/Hz du bruit de phase (théoriquement, on s'attendrait à un gain de 6 dBc/Hz, mais le transformateur présente des pertes et la synchronisation des oscillateurs est imparfaite). La figure 3D permet de vérifier que la pureté spectrale du signal est sensiblement améliorée.

L'invention a été décrite en référence à un mode de réalisation particulier, mais de nombreuses variantes sont envisageables. Par exemple :
- Le signal de contre-réaction s_cmbt pourrait être appliqué au deuxième oscillateur OSC2. Dans ce cas, la tension V_{MD} devrait être appliquée à l'entrée non inverseuse de l'amplificateur différentiel etla tension de référence à son entrée inverseuse.
- Les oscillateurs OSC1, OSC2 ne doivent pas nécessairement être des VCO.
- Les oscillateurs ne doivent pas nécessairement opérer dans le domaine des radiofréquences (1 MHz ou plus), voire des hyperfréquences (1 GHz ou plus) : l'invention convient également à des oscillateurs fonctionnant à plus basse fréquence.
- Les cellules actives des oscillateurs ne doivent pas nécessairement être du type à paire différentielle croisée ; d'autres topologies de circuit peuvent permettre d'obtenir une résistance de petit signal négatif. C'est le cas, notamment, des classiques montages « Colpitts » et « Hartley » à un seul transistor. L'utilisation d'une structure différentielle est néanmoins préférée.
- Les résonateurs électriques ne doivent pas nécessairement être du type LC parallèle. Si la fréquence de résonance peut être fixe, il peut même s'agir de résonateurs à cristal.
- Les transistors des oscillateurs ne doivent pas nécessairement être de type MOSFET. Il peut notamment s'agir de transistors bipolaires. Il est intéressant de noter que les transistors bipolaires sont sujets à un risque d'emballement thermique. Pour l'éviter, il est courant de connecter un résistor dit « de ballaste » aux émetteurs des transistors bipolaires en configuration d'émetteur commun ; cela a cependant l'inconvénient de dégrader le rendement énergétique du circuit. Dans le cas de l'invention, la boucle de contre-réaction qui stabilise la valeur de V_{MD} suffit à empêcher tout emballement thermique, même en l'absence de résistors de ballaste. L'efficacité énergétique des oscillateurs en technologie bipolaire s'en trouve améliorée.
- Il est avantageux d'injecter le courant de polarisation I_{dd} en correspondance des points milieux des inductances des oscillateurs. Cela, combiné avec l'utilisation de cellules actives de type différentiel, évite que les signaux d'oscillation puissent parcourir la boucle de contre-réaction, perturbant le fonctionnement du système. En variante, il est possible d'utiliser des condensateurs connectés à la masse pour filtrer les signaux d'oscillation dans la boucle de contre-réaction.
- La combinaison des signaux générés par les deux oscillateurs peut se faire par des moyens différents d'un transformateur, par exemple un diviseur de Wilkinson utilisé comme combineur.

## Revendications

1. Système électronique comprenant un premier (OSC1) et un second (OSC2) oscillateur mutuellement couplés et présentant une même fréquence de résonance, chaque dit oscillateur comprenant un résonateur électrique (RES1, RES2), une cellule active (CA1, CA2) ayant une résistance de petit signal négative reliée audit résonateur électrique, une borne d'alimentation électrique (AE1, AE2) de ladite cellule active, une sortie (S1, S2) pour un signal d'oscillation (s_osc1, s_osc2) et une borne de connexion (CM1, CM2) à un point de masse, **caractérisé en ce que** :
- la borne d'alimentation électrique (AE2) du second oscillateur et la borne (CM1) de connexion à un point de masse du premier oscillateur sont reliées à un même point (MD), dit de masse dynamique ; et **caractérisé en ce que** - le système comprend également un amplificateur différentiel (CMFB) présentant une première entrée (ED1) pouvant être connectée à une source de tension de référence (SVR), une seconde entrée (ED2) reliée audit point de masse dynamique (MD) et une sortie (SD) reliée à une borne (P) de contrôle du courant de polarisation de l'un parmi le premier et le deuxième oscillateur de manière à former une boucle de contre-réaction adaptée pour maintenir le potentiel dudit point de masse dynamique à un niveau constant, fonction de ladite tension de référence.

2. Système électronique selon la revendication 1 comprenant également un circuit combineur de signaux (TS) configuré pour additionner les tensions des signaux d'oscillation prélevés sur les sorties du premier et du deuxième amplificateur.

3. Système électronique selon la revendication 2 dans lequel ledit circuit combineur de signaux comprend un transformateur (TS) comprenant un premier (L1) et un deuxième (L2) enroulement primaire, respectivement reliés aux sorties du premier et du deuxième oscillateur, et deux enroulement secondaires (ES1, ES2) reliés en série et couplés respectivement au premier et au deuxième enroulement primaire.

4. Système électronique selon la revendication 3 dans lequel lesdits enroulements primaires sont des inductances des résonateurs électriques des oscillateurs.

5. Système électronique selon l'une des revendications 3 ou 4 dans lequel les bornes d'alimentation électrique (AE1, AE2) desdits premier et deuxième oscillateur sont reliées à des points milieux respectif desdits enroulements primaires (L1, L2).

6. Système électronique selon l'une des revendications précédentes, comprenant également ladite source de tension de référence (SVR), configurée pour générer ladite tension de référence (V_{REF}) de valeur égale à la moitié de celle de ladite tension d'alimentation (V_{dd}).

7. Système électronique selon l'une des revendications précédentes, dans lequel les résonateurs électriques desdits premier et deuxième oscillateur sont des circuits LC parallèles.

8. Système électronique selon l'une des revendications précédentes, dans lequel les cellules actives desdits premier et deuxième oscillateur comprennent chacune au moins un transistor ayant une grille ou base, la sortie dudit amplificateur différentiel étant reliée à la base du transistor de la cellule active du premier oscillateur.

9. Système électronique selon l'une des revendications précédentes dans lequel les cellules actives desdits premier et deuxième oscillateur comprennent chacune une paire différentielle de transistors croisés (T11, T12 ; T21, T22).

10. Système électronique selon la revendication 9 dans lequel :
- la sortie dudit amplificateur différentiel est reliée électriquement, en courant continu, à des grilles ou bases (G_T11, G_T12) des transistors croisés de la paire différentielle de la cellule active dudit premier oscillateur ; et
- la grilles ou base de chacun desdits transistor croisés de la paire différentielle de la cellule active dudit premier oscillateur est connectée au drain (D_T11, D_T12) ou collecteur de l'autre transistor de la paire par l'intermédiaire d'un condensateur de découplage (CD1, CD2).

11. Système électronique selon l'une des revendications précédentes dans lequel lesdits oscillateurs sont des oscillateurs commandés en tension, configurés pour être commandés ensemble de manière à présenter une même fréquence d'oscillation.

12. Système électronique selon l'une des revendications précédentes comprenant également une source (SVA) de tension continue d'alimentation reliée à la borne d'alimentation électrique dudit premier oscillateur.

13. Système électronique selon l'une des revendications précédentes, dans lequel lesdits oscillateurs sont des oscillateurs à radiofréquence.

14. Système électronique selon l'une des revendications précédentes, dans lequel lesdits oscillateurs sont co-intégrés de manière monolithique.

## Patentansprüche

1. Elektronisches System, umfassend einen ersten (OSC1) und einen zweiten (OSC2) wechselseitig gekoppelten Oszillator, welche eine gleiche Resonanzfrequenz aufweisen, wobei jeder Oszillator einen elektrischen Resonator (RES1, RES2), eine aktive Zelle (CA1, CA2), welche einen negativen Kleinsignalwiderstand besitzt, welcher mit dem elektrischen Resonator verbunden ist, eine elektrische Speisungsklemme (AE1, AE2) der aktiven Zelle, einen Ausgang (S1, S2) für ein Oszillationssignal (s_osc1, s_osc2) und eine Klemme zur Verbindung (CM1, CM2) mit einem Massenpunkt umfasst, **dadurch gekennzeichnet, dass**:
- die elektrische Speisungsklemme (AE2) des zweiten Oszillators und die Klemme (CM1) zur Verbindung mit einem Massenpunkt des ersten Oszillators mit einem gleichen Punkt (MD), benannt dynamischer Massenpunkt, verbunden sind; und **dadurch gekennzeichnet, dass**
das System ebenfalls einen Differenzialverstärker (CMFB) umfasst, welcher einen ersten Eingang (ED1) aufweist, welcher mit einer Referenzspannungsquelle (SVR) verbunden werden kann, einen zweiten Ausgang (ED2), welcher mit dem dynamischen Massenpunkt (MD) verbunden ist und einen Ausgang (SD), welcher mit einer Klemme (P) zur Steuerung des Polarisationsstroms eines des ersten und des zweiten Oszillators so verbunden ist, dass eine Gegenreaktionsschleife gebildet wird, welche geeignet ist, das Potenzial des dynamischen Massenpunktes auf einem konstanten Pegel zu halten, welcher von der Referenzspannung abhängt.

2. Elektronisches System nach Anspruch 1, ebenfalls umfassend einen Signalkombinierer-Schaltkreis (TS), welcher konfiguriert ist, um die Spannungen der Oszillationssignale zu addieren, welche an den Ausgängen des ersten Verstärkers und des zweiten Verstärkers entnommen werden.

3. Elektronisches System nach Anspruch 2, wobei der Signalkombinierer-Schaltkreis einen Transformator (TS) umfasst, welcher eine erste (L1) und eine zweite (L2) Primärwicklung, welche jeweils mit den Ausgängen des ersten und des zweiten Oszillators verbunden sind, und zwei Sekundärwicklungen (ES1, ES2) umfasst, welche in Reihe verbunden und jeweils mit der ersten und der zweiten Primärwicklung gekoppelt sind.

4. Elektronisches System nach Anspruch 3, wobei die Primärwicklungen Induktoren der elektrischen Resonatoren der Oszillatoren sind.

5. Elektronisches System nach einem der Ansprüche 3 oder 4, wobei die elektrischen Speisungsklemmen (AE1, AE2) des ersten und des zweiten Oszillators mit jeweiligen Mittelpunkten der Primärwicklungen (L1, L2) verbunden sind.

6. Elektronisches System nach einem der vorhergehenden Ansprüche, ebenfalls umfassend die Referenzspannungsquelle (SVR), welche konfiguriert ist, um die Referenzspannung (V_{REF}) mit einem Wert zu erzeugen, welcher der Hälfte des Wertes der Speisungsspannung (V_{dd}) entspricht.

7. Elektronisches System nach einem der vorhergehenden Ansprüche, wobei die elektrischen Resonatoren des ersten und des zweiten Oszillators parallele LC-Schaltkreise sind.

8. Elektronisches System nach einem der vorhergehenden Ansprüche, wobei die aktiven Zellen des ersten und des zweiten Oszillators jeweils mindestens einen Transistor mit einem Gitter oder einer Basis umfassen, wobei der Ausgang des Differenzialverstärkers mit der Basis des Transistors der aktiven Zelle des ersten Oszillators verbunden ist.

9. Elektronisches System nach einem der vorhergehenden Ansprüche, wobei die aktiven Zellen des ersten und des zweiten Oszillators jeweils ein Differenzialpaar gekreuzter Transistoren (T11, T12; T21, T22) umfassen.

10. Elektronisches System nach Anspruch 9, wobei:
- der Ausgang des Differenzialverstärkers elektrisch mit Gleichstrom mit Gittern oder Basen (G_T11, G T12) der gekreuzten Transistoren des Differenzialpaars der aktiven Zelle des ersten Oszillators verbunden ist; und
- das Gitter oder die Basis eines jeden der gekreuzten Transistoren des Differenzialpaars der aktiven Zelle des ersten Oszillators mit dem Drain (D_T11, D_T12) oder Sammler des anderen Transistors des Paars durch einen Entkopplungskondensator (CD1, CD2) verbunden ist.

11. Elektronisches System nach einem der vorhergehenden Ansprüche, wobei die Oszillatoren spannungsgesteuerte Oszillatoren sind, welche dazu konfiguriert sind, gemeinsam gesteuert zu werden, um eine gleiche Oszillationsfrequenz aufzuweisen.

12. Elektronisches System nach einem der vorhergehenden Ansprüche, ebenfalls umfassend eine Speisungs-Gleichspannungsquelle (SVA) welche mit der elektrischen Speisungsklemme des ersten Oszillators verbunden ist.

13. Elektronisches System nach einem der vorhergehenden Ansprüche, wobei die Oszillatoren Funkfrequenzoszillatoren sind.

14. Elektronisches System nach einem der vorhergehenden Ansprüche, wobei die Oszillatoren monolithisch kointegriert sind.

## Claims

1. Electronic system comprising a first (OSC1) and a second (OSC2) oscillator that are mutually cross-coupled and have one and the same resonant frequency, each said oscillator comprising an electrical resonator (RES1, RES2), an active cell (CA1, CA2) having a negative small-signal resistance linked to said electrical resonator, an electric power supply terminal (AE1, AE2) of said active cell, an output (S1, S2) for an oscillation signal (s_osc1, s_osc2) and a terminal (CM1, CM2) for connection to a ground point, **characterized in that**:
- the electric power supply terminal (AE2) of the second oscillator and the terminal (CM1) for connection to a ground point of the first oscillator are linked to one and the same point (MD), termed dynamic ground; and **characterized in that**
- the system also comprises a differential amplifier (CMFB) having a first input (ED1) that is able to be connected to a reference voltage source (SVR), a second input (ED2) linked to said dynamic ground point (MD), and an output (SD) linked to a terminal (P) for controlling the bias current of one from the first and the second oscillator so as to form a feedback loop designed to maintain the potential of said dynamic ground point at a constant level, dependent on said reference voltage.

2. Electronic system according to claim 1, also comprising a signal combiner circuit (TS) configured to add the voltages of the oscillation signals taken at the outputs of the first and of the second amplifier.

3. Electronic system according to claim 2, wherein said signal combiner circuit comprises a transformer (TS) comprising a first (L1) and a second (L2) primary winding, which are linked to the outputs of the first and of the second oscillator, respectively, and two secondary windings (ES1, ES2), which are linked in series and coupled to the first and to the second primary winding, respectively.

4. Electronic system according to claim 3, wherein said primary windings are inductors of the electrical resonators of the oscillators.

5. Electronic system according to either of claim 3 or claim 4, wherein the electric power supply terminals (AE1, AE2) of said first and second oscillator are linked to respective mid-points of said primary windings (L1, L2).

6. Electronic system according to one of the preceding claims, also comprising said reference voltage source (SVR), configured to generate said reference voltage (V_{REF}) with a value equal to half the value of said supply voltage (V_{dd}).

7. Electronic system according to one of the preceding claims, wherein the electrical resonators of said first and second oscillator are parallel LC circuits.

8. Electronic system according to one of the preceding claims, wherein the active cells of said first and second oscillator each comprise at least one transistor having a gate or base, the output of said differential amplifier being linked to the base of the transistor of the active cell of the first oscillator.

9. Electronic system according to one of the preceding claims, wherein the active cells of said first and second oscillator each comprise a differential pair of cross-coupled transistors (T11, T12; T21, T22).

10. Electronic system according to claim 9, wherein:
- the output of said differential amplifier is linked electrically, through DC current, to gates or bases (G_T11, G T12) of the cross-coupled transistors of the differential pair of the active cell of said first oscillator; and
- the gate or base of each of said cross-coupled transistors of the differential pair of the active cell of said first oscillator is connected to the drain (D_T11, D_T12) or collector of the other transistor of the pair by way of a decoupling capacitor (CD1, CD2).

11. Electronic system according to one of the preceding claims, wherein said oscillators are voltage-controlled oscillators, configured to be controlled jointly so as to have one and the same oscillation frequency.

12. Electronic system according to one of the preceding claims, also comprising a DC voltage power source (SVA) linked to the electric power supply terminal of said first oscillator.

13. Electronic system according to one of the preceding claims, wherein said oscillators are radiofrequency oscillators.

14. Electronic system according to one of the preceding claims, wherein said oscillators are co-integrated in a monolithic manner.
